## Europäisches Patentamt
## European Patent Office
## Office européen des brevets

(19)

(11) Numéro de publication : **0 128 822**
**B1**

(12)
# FASCICULE DE BREVET EUROPÉEN

(45) Date de publication du fascicule du brevet :
09.09.87

(51) Int. Cl.⁴ : **G 06 K 19/06**, H 01 L 21/56,
H 01 L 23/14

(21) Numéro de dépôt : **84401155.1**

(22) Date de dépôt : **06.06.84**

(54) **Procédé de fabrication de cartes à mémoire et cartes obtenues suivant ce procédé.**

(30) Priorité : 09.06.83 FR 8309558
29.11.83 FR 8318993

(43) Date de publication de la demande :
19.12.84 Bulletin 84/51

(45) Mention de la délivrance du brevet :
09.09.87 Bulletin 87/37

(84) Etats contractants désignés :
BE CH DE GB IT LI NL SE

(56) Documents cités :
EP-A- 0 068 539
DE-C- 3 151 408
FR-A- 2 337 381
FR-A- 2 520 541
GB-A- 2 081 974
ELECTRONIQUE INDUSTRIELLE, no. 15, 1 mai 1981,
pages 87-88, Paris, FR; "Carte de paiement électronique: la version du LEP"
ELECTRONIQUE, no. 279, février 1980, pages 11-12,
Paris, FR; Des micro-ordinateurs multiples dans une
carte de crédit"

(73) Titulaire : **FLONIC S.A.**
**12, Place des Etats-Unis**
**F-92120 Montrouge (FR)**

(72) Inventeur : **Rebjock, Alain**
**28, chemin des Bourgones**
**F-95000 Cergy (FR)**
Inventeur : **Rose, René**
**15, rue de l'Etang**
**F-78190 Voisibs le Bretonneux (FR)**

(74) Mandataire : **Dronne, Guy et al**
**Giers Schlumberger 12 Place des Etats-Unis B.P. 121**
**F-92124 Montrouge (FR)**

Jouve, 18, rue St-Denis, 75001 Paris, France

## Description

La présente invention est relative aux cartes portatives à mémoire, du type contenant un circuit intégré, et notamment à la fabrication de telles cartes suivant un procédé économique.

L'invention est plus précisément applicable aux cartes à prépaiement, c'est-à-dire à des cartes auxquelles est attribuée initialement une certaine valeur fiduciaire, l'achat d'une carte contre le paiement de cette valeur permettant d'obtenir certaines prestations de service par annulations successives ou changements d'état d'éléments de mémoire affectés d'une valeur unitaire jusqu'à épuisement de la valeur totale de la carte.

Il a déjà été proposé pour l'obtention de prestations, par exemple de communications téléphoniques, d'utiliser une carte à mémoire de type électronique dont la mémoire est constituée d'éléments qui, au fur et à mesure de l'utilisation de la carte, sont successivement basculés d'un état initial à un second état de façon irréversible, la carte devenant inutilisable quand tous les éléments de sa mémoire sont passés dans le second état. La carte n'étant pas rechargeable, autrement dit les éléments de sa mémoire ne pouvant être ramenés à leur état initial, elle doit être jetée. Il importe alors que son prix de revient soit le plus faible possible pour limiter au maximum la valeur de la matière consommable.

On connaît déjà des procédés de fabrication de cartes à mémoire électronique de format normalisé, suivant lesquels le circuit intégré est logé dans une cavité pratiquée dans la carte, cavité qui est ensuite remplie, totalement ou partiellement, d'un matériau d'enrobage, puis fermée par une feuille mince ne laissant apparaître que les plages métalliques pour la connexion du circuit intégré avec un appareil d'échanges de données avec la carte. Ces procédés mettent généralement en œuvre un nombre important d'opérations délicates telles que : préparation d'une cavité et d'un module de circuit intégré monté sur un support adapté, insertion et collage de cet ensemble dans la cavité, enrobage de l'ensemble et fermeture de la cavité, pressage final et détourage de la carte. De tels procédés sont trop onéreux pour être appliqués à la fabrication de cartes destinées à être jetées après usage.

Un tel procédé d'implantation du module électronique dans le corps de la carte est notamment connu par le brevet français 2 337 381 et par le brevet allemand 3 151 408.

L'invention a donc pour objet un procédé de fabrication permettant d'obtenir de façon économique des cartes à mémoire et ne nécessitant qu'un nombre d'opérations limité.

Suivant l'invention, le procédé de fabrication de carte à mémoire du type comprenant un circuit intégré noyé à l'intérieur d'un matériau plastique constituant le support de la carte et selon lequel on fournit un module électronique comprenant un substrat isolant muni de plages de contact métallisées disposées sur une première face dudit substrat, et une pastille formant un circuit intégré montée sur une deuxième face dudit substrat, ledit module ayant une épaisseur inférieure à l'épaisseur de ladite carte, caractérisé en ce que :

on porte localement, à sa température de ramollissement, ledit matériau plastique à l'emplacement où on veut enfoncer ledit module ; et

simultanément, on applique avec pression ledit module sur une face de ladite carte audit emplacement ramolli pour enfoncer ledit module dans ledit matériau jusqu'à ce que ledit module électronique soit disposé dans l'épaisseur de ladite carte et que lesdites plages de contact affleurent sensiblement ladite face de la carte ; ledit procédé comportant en outre l'étape de relier électriquement les bornes dudit circuit intégré auxdites plages de contact métallisées lors de la fourniture dudit module électronique ou après l'implantation dudit module électronique dans le support de la carte.

De préférence, on chauffe le module électronique lui-même pour que celui-ci, à son tour, échauffe localement par contact le matériau plastique, provoquant ainsi son ramollissement.

L'utilisation du module lui-même comme poinçon d'une part, et le chauffage local du matériau plastique de la carte d'autre part, permettent de supprimer certaines des opérations énumérées plus haut, notamment la préparation d'une cavité ayant la forme de l'ensemble du module, l'insertion et le collage du module dans la cavité, la fermeture de la cavité et le détourage de la carte.

On comprend que l'utilisation du substrat isolant comme poinçon pour réaliser une partie de la cavité dans laquelle sera finalement logé le module électronique permet d'éviter d'avoir à pré-former dans la carte une cavité avec des cotes très précises. En outre, la fusion ou le ramollissement localisé du matériau plastique permet d'améliorer l'adhérence entre le module électronique et le matériau plastique formant le corps de la carte. En outre, les déformations du matériau plastique sont très limitées, compte tenu, en particulier, du mode de chauffage utilisé et ces déformations n'entraînent aucune modification sensible des cotes externes de la carte. Enfin, le mode de réalisation du module électronique lui-même permet d'utiliser un circuit imprimé simple face et évite en outre d'avoir à métalliser des trous traversant le substrat isolant pour assurer la connexion électrique entre les plages de contact disposées sur une face du subtrat isolant et le circuit intégré disposé sur l'autre face de ce substrat.

L'invention a aussi pour objet une carte à mémoire réalisée suivant le procédé précédent

La carte, suivant l'invention, comprend dans une feuille de matériau plastique, une pastille formant un circuit intégré montée sur une face d'un substrat isolant présentant des plages de contact métallisées au niveau de la surface de ladite feuille, lesdites plages étant disposées sur la face du substrat opposée à celle sur laquelle est montée la pastille et reliées aux bornes du circuit par un réseau de connexions caractérisée en ce que la feuille de matériau plastique présente un logement formé au moins en partie par l'enfoncement dudit module dans celle-ci et en ce que ledit substrat comporte une pluralité d'orifices au moins partiellement remplis par ledit matériau plastique formant ladite feuille.

De préférence la liaison électrique avec les plages de contact est réalisée par métallisation de la paroi d'au moins certains desdits orifices.

Selon une réalisation préférée ledit support isolant comprend une fenêtre centrale dans laquelle est logée partiellement ladite pastille et des fenêtres périphériques dans lesquelles est logée une des extrémités desdites connexions électriques, et ledit corps de la carte comprend un orifice débouchant dans sa deuxième face dans lequel sont logés une partie de ladite pastille et lesdites connexions électriques, ledit orifice étant rempli par un matériau isolant qui remplit également la portion de la fenêtre centrale non occupée par la pastille et lesdites fenêtres périphériques.

L'invention sera mieux comprise en se référant à la description suivante et au dessin annexé donné à titre d'exemple non limitatif. Sur ce dessin :

la figure 1 représente une carte obtenue par un premier mode de mise en œuvre du procédé selon l'invention ;

la figure 2 est une vue en coupe transversale à plus grande échelle suivant la ligne II-II de la figure 1 selon un premier mode de mise en œuvre de l'invention ;

la figure 3 représente schématiquement la phase d'implantation d'un module selon le premier mode de mise en œuvre du procédé de l'invention ;

les figures 4 et 5 illustrent les différentes étapes d'une variante de mise en œuvre du procédé selon le premier mode de réalisation.

les figures 6 à 10 illustrent les différentes étapes d'une réalisation du module électronique, la figure 6 montrant en vue de dessus une bande de substrat isolant, les figures 7 à 9 montrant en section verticale les étapes successives d'implantation sur le substrat du circuit intégré, et les figures 10a et 10b montrant des demi-vues respectivement de dessus et de dessous du module électronique terminé ;

la figure 11 illustre, en coupe verticale, l'implantation du module électronique selon les Figures 6 à 10 dans le corps de la carte ;

la figure 12 montre, en coupe verticale, le module électronique implanté dans le corps de la carte ; et

la figure 13 montre, en vue de dessus, une carte dans laquelle le module électronique selon les figures 6 à 10 a été implanté.

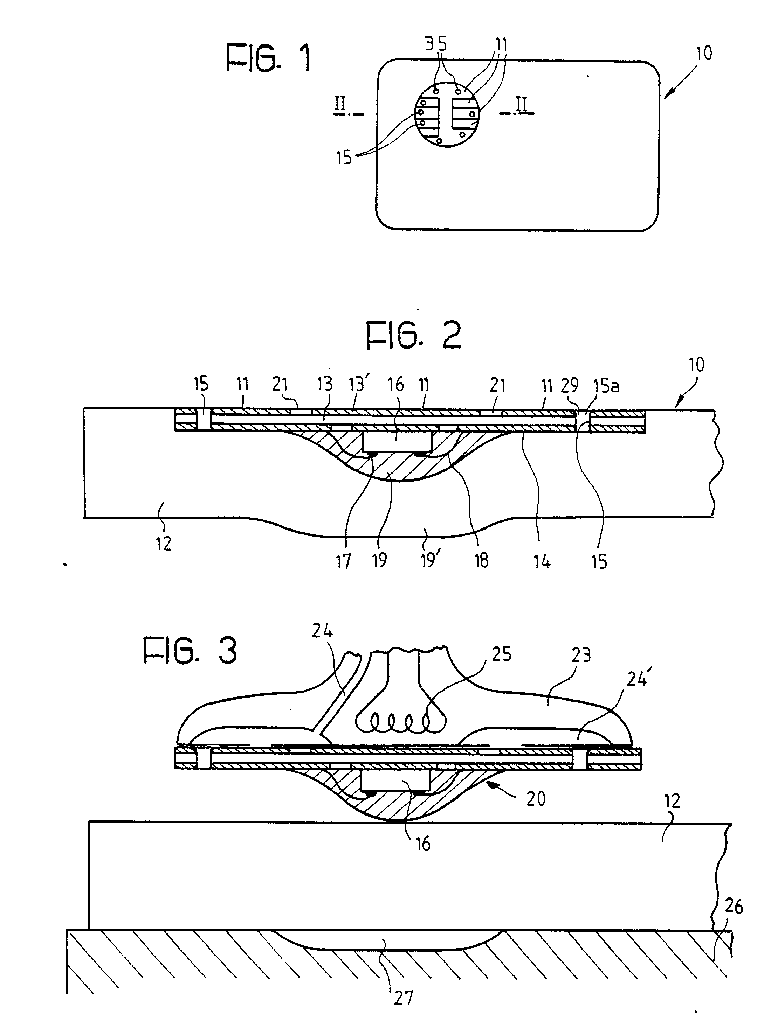

En se référant aux figures 1 et 2, on voit une carte à mémoire 10 réalisée conformément au premier mode de mise en œuvre du procédé de l'invention. La carte 10 comporte sur sa face supérieure, visible à la figure 1, une série de plages métalliques 11 situées dans le coin supérieur gauche et servant à relier électriquement le circuit électronique renfermé dans la carte avec un appareil d'exploitation et d'échange de données. La carte est constituée par une feuille unique 12 de matière plastique souple, par exemple du chlorure de polyvinyle (PVC) de dimensions normalisées. Les plages 11 sont obtenues à partir d'une métallisation réalisée sur la face 13' d'un substrat électriquement isolant 13, par exemple en polyimide en polyester ou en verre époxy ; le substrat 13 présente aussi sur sa face inférieure des zones conductrices 14 correspondant aux plages 11 et obtenues également à partir d'une métallisation initiale. Les plages 11 et les zones conductrices 14 sont de préférence électriquement reliées par des trous dont la paroi est métallisée 15 qui traversent toute l'épaisseur du substrat isolant, mais dont la partie centrale est exempte de métallisation. Le substrat 13 sert de support à une pastille de circuit intégré 16 qui est montée, par exemple par collage, sur celui-ci par sa face opposée à celle où se trouvent les bornes de contact 17 du circuit. Les bornes 17 sont reliées aux zones conductrices 14 par un réseau de connexions 18.

Cet ensemble forme un module électronique 20. La pastille de circuit intégré 16 et son réseau de connexions 18 sont noyés dans un enrobage en matériau électriquement isolant 19, d'épaisseur inférieure à celle de la feuille 12, par exemple une résine époxy H7OE de la marque EPOTECNI qui polymérise à 100 °C au bout d'une heure environ. Ainsi, non seulement l'enrobage joue le rôle d'isolant électrique mais également il sert à la rigidification de l'ensemble et, par sa forme extérieure analogue à celle d'une goutte, il facilite l'enfoncement du module électronique dans le matériau plastique.

Ce matériau, contrairement aux réalisations habituelles n'est pas un matériau souple et élastique, mais un matériau rigide. Le circuit 16 est ainsi électriquement accessible par l'intermédiaire des plages de contact 11, des trous métallisés 15, des zones métallisées 14 et des connexions du réseau 18. Il est à remarquer que les trous 15 ne sont métallisés que sur leur paroi et que leur intérieur est rempli par le PVC de la feuille 12 comme cela sera expliqué ultérieurement. Cela contribue à former un ancrage du substrat 13 dans la feuille 12.

Le procédé de fabrication permettant de réaliser une carte suivant la structure qui vient d'être décrite aux figures 1 et 2 est le suivant : on part d'un substrat 13, métallisé sur ses deux faces, par exemple par laminage, et/ou apport électrolytique de métal et on réalise les zones 11 et 14 avec leur configuration désirée par photogravure. On perce les trous 15 et on les métallise de façon habituelle.

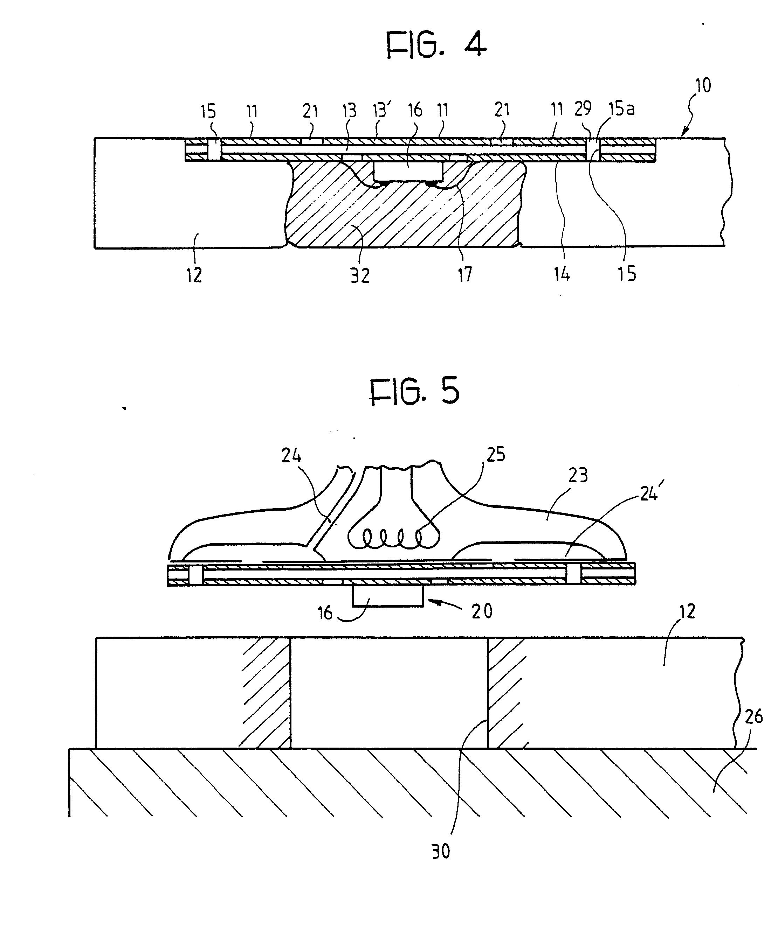

De plus l'extrémité 15a de chaque orifice 15 est évasée. Cela peut être obtenu en prévoyant un lamage dans la couche de métallisation autour de l'extrémité de l'orifice. On place ensuite le circuit intégré 16 contre une des faces du substrat 13 et on soude ses connexions 18 sur les zones conductrices 14. On dépose alors sur la pastille 16 le matériau d'enrobage 19, telle qu'une goutte de colle époxy dure, qu'on laisse durcir pendant 1 heure à une température de l'ordre de 100 °C. Le module électronique 20 ainsi réalisé, représenté figure 3, est suffisamment rigide, après durcissement, pour pouvoir être implanté dans la carte. Le substrat 13 est en effet réalisé en verre époxy et métallisé sur la majeure partie de ses deux faces à l'exception de minces lignes non conductrices 21 séparant les différentes zones conductrices 11 et 14. Les métallisations qui ont chacune une épaisseur de l'ordre de 35 microns rigidifient sensiblement le substrat isolant qui a une épaisseur de l'ordre de 100 microns. Le substrat forme avec le matériau d'enrobage convenablement durci un ensemble rigide capable d'agir à la manière d'un poinçon.

Selon le premier mode de mise en œuvre illustré par les figures 2 et 3, le module électronique est tenu de préférence par un outil symbolisé par la référence 23. Le module est tenu par l'outil 23 grâce à un système d'aspiration symbolisé par la conduite 24 débouchant dans la cavité 24' de l'outil. L'outil a des dimensions telles que les orifices 15 du module électronique se trouvent vis à vis de la cavité 24'. En outre, l'outil 23 est muni de moyens de chauffage symbolisés par la résistance 25.

La feuille 12 formant le support de la carte est placée sur un bâti 26 muni d'un léger évidement 27. La feuille 12 est placée de telle manière que la zone de la feuille 12 où l'on veut enfoncer le module électronique soit disposée au dessus dudit évidement 27. Le système de chauffage 25 est alimenté pour porter le module électronique à une température de l'ordre de 170 °C. L'outil 23 applique le module électronique sur la face supérieure de la feuille 12 avec une pression locale de l'ordre de $2.10^5$ Pa. Par contact, le matériau plastique est localement porté à sa température de ramollissement, c'est-à-dire à environ 50 °C. Par la combinaison de la pression et du chauffage localisé, le module est enfoncé jusqu'à ce que les plages 11 affleurent sensiblement la face supérieure de la feuille 12. Le fluage du matériau plastique, sous l'effet de l'enfoncement du module électronique entraine le remplissage des orifices 15, ce remplissage étant encore favorisé par l'effet d'aspiration produit par l'outil 23. Le reste de la déformation du matériau plastique par fluage est localisé dans l'évidement 27 du bâti 26. Puis, alors que le matériau plastique est encore à l'état ramolli, on supprime l'aspiration, et on la remplace par une légère suppression. Cela a pour effet d'« aplatir » l'extrémité supérieure des remontées 29 de matériau plastique dans les orifices 15 pour qu'elles remplissent les parties évasées 15a. Ainsi les remontées 29 jouent le rôle de rivets, assurant au moins partiellement l'ancrage du module électronique dans la feuille 12.

Il faut ajouter que le fluage du matériau plastique étant localisé en 19' par l'évidement 27, les cotes externes de la carte ne sont modifiées que dans cette zone, et l'opération finale de détourage de la carte devient inutile.

Pour améliorer encore l'ancrage du module électronique dans la carte, il est possible de ménager dans le substrat isolant 13 des orifices supplémentaires tels que 35 sur la figure 1 qui n'ont aucune fonction de liaison électrique et qui ne sont donc pas métallisés. Ces orifices supplémentaires peuvent en particulier, être prévus à proximité de la périphérie du substrat dans des zones dépourvues d'orifices 15 pour la liaison électrique.

Dans une fabrication en série, les opérations de soudage des connexions et d'enrobage des pastilles de circuit intégré peuvent avantageusement être réalisées en série sur un film de substrat défilant pas à pas, film sur lequel ont été élaborés à intervalles réguliers des ensembles de zones conductrices et de trous métallisés suivant la configuration voulue. Une opération de découpe du module dans le film doit alors précéder l'opération d'implantation dans les cartes.

Les figures 4 et 5 illustrent une variante d'implantation du module électronique dans la feuille 12 en matière plastique. Comme le montre mieux la figure 4 on part d'un module électronique constitué par un substrat isolant 13 identique à celui de la figure 2 ou 3 sur une face duquel est fixé le circuit intégré 16.

Il faut observer que les connexions 18 de la figure 2 ne sont pas réalisées et qu'il n'y a donc pas l'enrobage 19. En outre, dans la feuille 12 on a ménagé un orifice 30, la traversant totalement. Cet orifice a, en section droite, des dimensions inférieures à celles du substrat isolant 13, mais nettement supérieures à celles du circuit intégré 16.

Le module électronique est posé sur la face supérieure de la feuille de telle manière que le circuit intégré 16 pénètre dans l'orifice 30. Puis, comme cela a déjà été expliqué en liaison avec les figures 2 et 3, on exerce une certaine pression sur le substrat tout en portant localement la feuille 12 à sa température de ramollissement. Pour cela le module électronique est tenu par l'outil 23 déjà décrit.

Par ce processus, la périphérie du substrat s'enfonce dans le matériau plastique jusqu'à ce que les plages conductrices affleurent la face supérieure de la feuille 12. Durant cette opération il se produit un certain fluage. Il faut cependant observer que ce fluage est moins important que dans le premier mode de mise en œuvre en raison de la présence de l'orifice 30. Ce fluage se localise dans la zone laissée libre par l'orifice 30, ce qui est sans effet sur la forme extérieure finale de la carte. Il permet en outre au matériau plastique de venir remplir les orifices 15, cette opération étant favorisée par l'aspiration due à l'outil.

Dans l'étape suivante on réalise de façon connue les connexions électriques 18 entre les bornes de circuit intégré et les métallisations. Enfin, on remplit la portion de l'orifice 30 non

occupée par le circuit intégré à l'aide d'un dépôt isolant 32, par exemple de résine époxy.

Cette variante du procédé présente certains avantages. L'implantation du module électronique n'entraîne aucune modification des cotes externes de la carte. De plus la réalisation des connexions 18 entre le circuit intégré et les métallisations est simplifiée. En effet dans cette variante ces connexions sont réalisées après que le module électronique ait été mis en place dans la carte. En conséquence, la pièce à manipuler pour souder ces connexions se limite à la carte elle-même, et ses dimensions sont réduites. Dans le premier mode de mise en œuvre, c'est l'ensemble de la bande portant les différents circuits intégrés qu'il faut manipuler pour souder les différentes connexions et la longueur de cette bande n'est pas négligeable.

Il résulte de la description précédente que, dans tous les cas, au moins une partie du module électronique constitué par le circuit intégré et le substrat sert de poinçon pour provoquer l'enfoncement du module électronique dans la carte, le matériau plastique formant celle-ci étant localement porté à sa température de ramollissement.

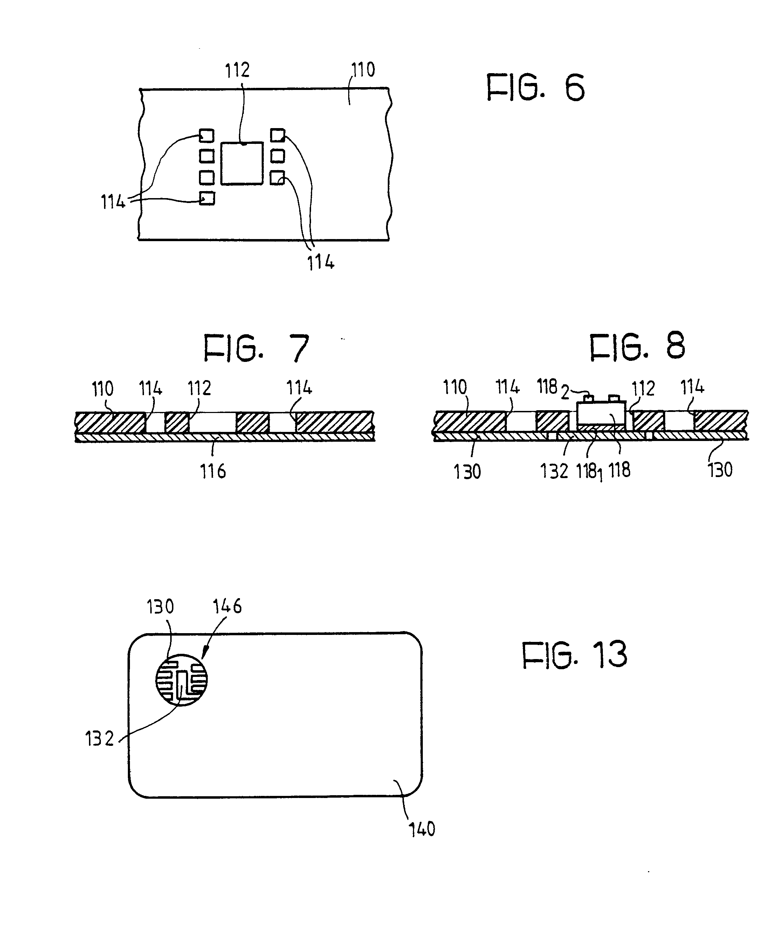

En se référant tout d'abord aux figures 6 à 10, on va décrire une variante de réalisation du module électronique.

Sur la figure 6 on a représenté une portion d'une bande mince en matériau isolant 110. La bande a par exemple une épaisseur de 120 microns et elle est réalisée dans un matériau isolant de préférence souple. Cela peut être le matériau commercialisé sous la marque KAPTON, ou un tissu de fibres de verre recouvert d'époxy. Dans cette bande on réalise des ensembles de fenêtres dont un seul est représenté sur la figure 6. Pour chaque ensemble on trouve une fenêtre centrale 112 carrée et des fenêtres périphériques 114. Dans l'exemple considéré il y a 7 fenêtres périphériques disposées selon deux lignes situées de part et d'autre de la fenêtre centrale carrée 112 et transversales par rapport à la grande longueur de la bande.

Dans le cas décrit on utilise la technique dite TAB pour réaliser le module électronique, c'est-à-dire que sur la même bande 110 on réalise plusieurs modules électroniques. On pourrait également réaliser individuellement les modules électroniques en partant de supports isolants découpés aux dimensions requises.

Comme le montre la figure 7 on revêt une face du substrat isolant 110 d'une couche métallique 116 par laminage ou tout autre procédé connu. La couche métallique 116 a par exemple une épaisseur de l'ordre de 30 microns. La couche 116 est gravée par des procédés bien connus pour définir un ensemble de plages de contact électrique comme cela sera expliqué ultérieurement.

Dans l'étape suivante, représentée sur la figure 8, on colle une pastille de circuit intégré 118 sur la portion de la couche de métallisation 116 en regard de la fenêtre centrale 112. La fenêtre 112 a en section droite, c'est-à-dire en regardant le substrat isolant de dessus, des dimensions supérieures à celles du circuit intégré pour permettre de recevoir celui-ci. Le circuit intégré 118 est collé sur la métallisation 116 à l'aide d'une couche de colle conductrice référencée 120. On réalise ainsi une connexion électrique de surface relativement importante entre une partie de la couche métallique 116 et la face postérieure $118_1$ du circuit intégré 118, c'est-à-dire la face sur laquelle ne sont pas disposées des bornes de connexion $118_2$ du circuit intégré 118. Cette solution est particulièrement avantageuse lorsque le circuit intégré est réalisé en technologie N-MOS. De plus, la place de connexion en regard de la fenêtre centrale 112 sert de support de fixation de la pastille 118.

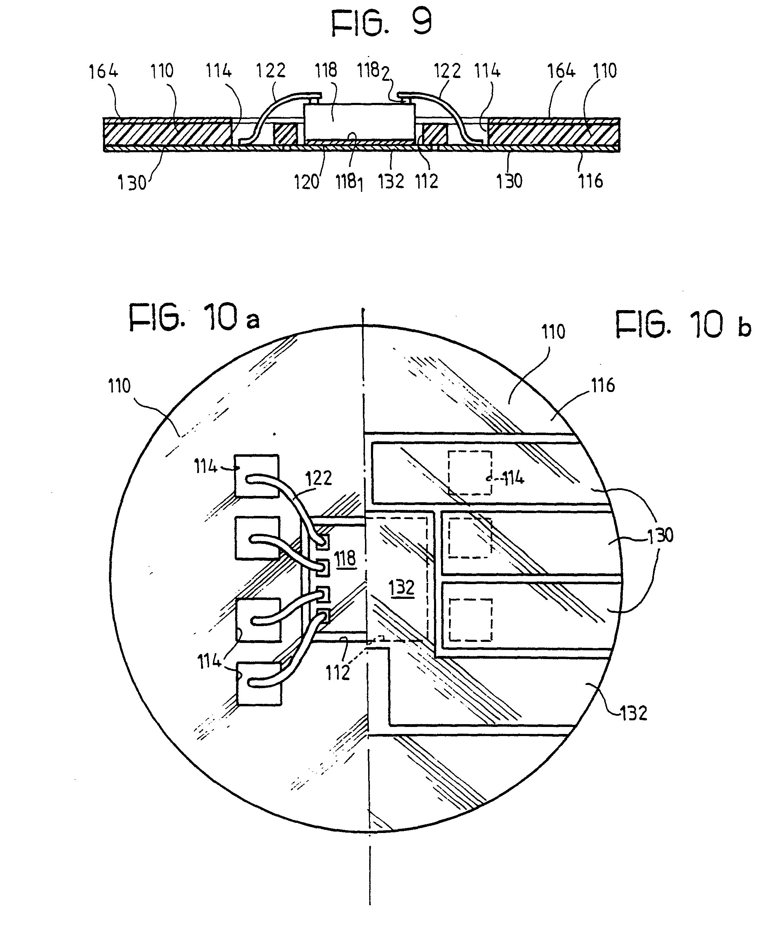

Dans la phase suivante, représentée sur la figure 9 on vient mettre en place des fils conducteurs, tels que 122. Une première extrémité de chaque fil conducteur 122 est soudée sur une des bornes $118_2$ du circuit intégré et l'autre extrémité de chaque fil conducteur 122 pénètre dans une des fenêtres périphériques 114 et est soudée par exemple par ultra sons, sur la face dénudée de la couche de métallisation 116 en regard de ladite fenêtre 114.

Enfin la bande 110 de matériau isolant est découpée pour donner au module sa forme finale qui est par exemple circulaire comme le montrent les figures 10a et 10b.

La figure 10b montre plus précisément en vue de dessus la forme des différentes plages de métallisation. On voit en particulier que par gravure on a défini des plages de métallisation 130 associées chacune à une des fenêtres périphériques 114 respective et une métallisation 132 qui est disposée en dessous de la fenêtre centrale 112. Cette métallisation centrale 132 forme la plage de contact de mise à la masse du circuit électronique 118.

Outre les avantages déjà mentionnés, le procédé décrit ci-dessus permet de réduire l'épaisseur totale du module électronique puisque la pastille semi-conductrice est partiellement logée dans l'épaisseur du substrat isolant. De plus, les usinages réalisés dans le substrat isolant sont simples puisqu'ils consistent en des fenêtres traversant toute l'épaisseur du substrat, et ne nécessitant pas un positionnement relatif très précis du fait de la souplesse des fils de connexion 122.

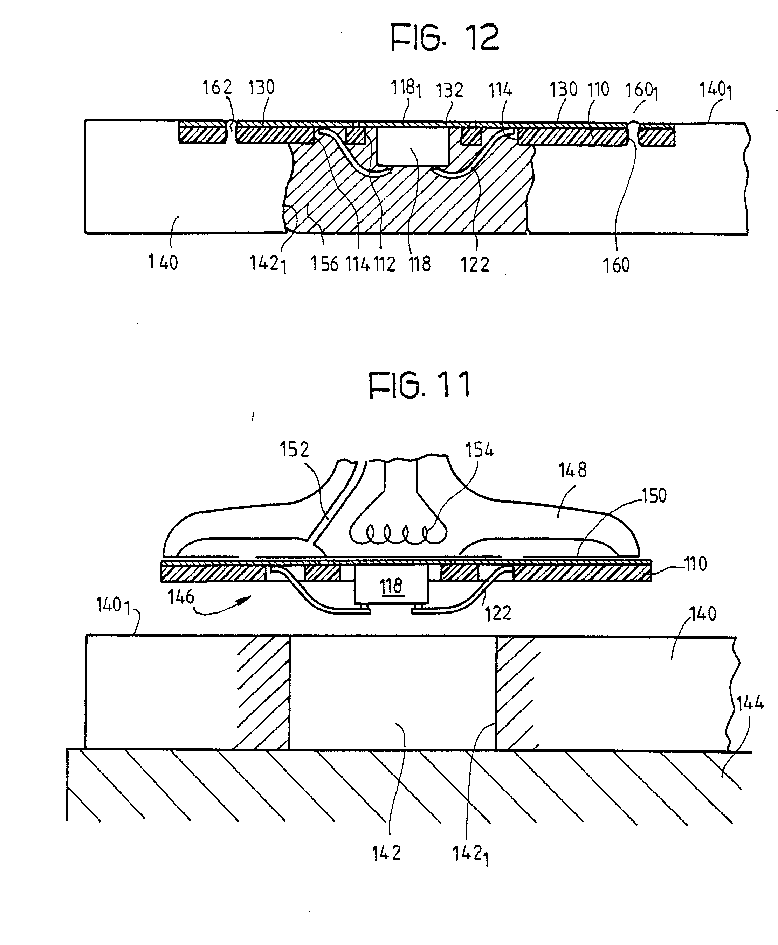

En se référant maintenant aux figures 11 et 12 on va expliquer le mode d'implantation du module électronique ainsi réalisé dans le corps de la carte.

Comme on le voit mieux sur la figure 13 la carte est constituée essentiellement par un corps en matériau plastique, par exemple en PVC, de forme générale rectangulaire et dont l'épaisseur est par exemple de 0,762 mm. Dans un premier temps, comme le montre la figure 12, on perce dans le corps de la carte un orifice, par exemple cylindrique, 142 dont la section parallèle au plan de la carte est supérieure à la surface de la zone occupée par l'ensemble des fenêtres 112 et 114 réalisées dans le substrat isolant 110 mais inférieure à la surface totale du support isolant 110. La carte 140 est mise en place sur un bâti isolant thermique 144. Pour son implantation, le module électronique, qui porte la référence générale 146 sur la figure 11, est tenu par un outil 148 qui agit sur la face du module électronique portant les plages de contact 130. Par exemple, l'outil est du type à dépression, c'est-à-dire qu'on réalise dans une cavité 150 de l'outil fermée par le substrat isolant du module électronique 146 un certain vide à l'aide d'une pompe à vide. On a symbolisé par 152 une conduite destinée à être reliée à la pompe à vide et débouchant dans l'évidement 150. A l'aide de l'outil 148 le module électronique est saisi et posé sur un emplacement $140_1$ de la face supérieure du corps de la carte 140 autour de l'orifice 142 de telle manière que la pastille 118 pénètre dans l'orifice 142 ainsi que les fils de connexion 122.

Pour réaliser l'implantation du module 146 dans le corps de la carte, on exerce une certaine pression, par exemple de l'ordre de $2.10^5$ Pa, sur le module tout en chauffant localement le matériau plastique formant le corps de la carte dans la zone où doit pénétrer le substrat isolant. De préférence, pour réaliser cet échauffement localisé, l'outil 148 est muni de moyens de chauffage symbolisés par la résistance chauffante 154. Ainsi, par contact entre le module électronique et le matériau plastique formant la carte, la matière plastique est ramollie localement dans la zone de contact. La température de ramollissement étant de l'ordre de 50 °C, le module électronique lui-même est porté à une température de l'ordre de 170 °C. Sous l'effet conjugué du ramollissement et de la pression exercée par l'outil 148, la périphérie du substrat isolant du module 146 agit à la façon d'un poinçon pour pénétrer dans le matériau plastique. On arrête l'application de la pression lorsque les plages de contact 130, 132 du module électronique affleurent la face supérieure du corps de la carte à l'emplacement $140_1$. Lors de l'enfoncement de la périphérie du substrat isolant, le matériau plastique formant le corps de la carte est partiellement refoulé pour déformer la paroi de l'orifice 142. Sur la figure 12 on a représenté la paroi $142_1$ de l'orifice 142 déformée après le refoulement du matériau plastique. Ainsi la déformation ne s'étend pas jusqu'aux bords externes de la carte et n'affecte donc pas les caractéristiques externes dimensionnelles de la carte qui sont normalisées. Ensuite, comme cela est représenté sur la figure 12, on remplit l'orifice 142, ou du moins la partie qui n'est pas occupée par le module électronique 146, à l'aide d'une résine époxy isolante référencée 156. Durant cette opération, on voit que les plages de contact 130, 132, en fermant les fenêtres 112 et 114, servent de plus à éviter que la résine époxy ne remonte au-dessus du niveau de la face supérieure du corps de la carte.

Selon une variante de mise en œuvre du procédé, le module électronique peut être réalisé comme décrit précédemment, mais les fils de connexion 122 ne sont pas mis en place. Le module ainsi réalisé est implanté dans le corps de la carte. Puis, à travers l'orifice 142 on soude les fils de connexion 122 sur les bornes de la pastille et sur les plages de contact en regard des fenêtres périphériques.

Enfin, on remplit l'orifice 142 à l'aide de la résine époxy isolante 156.

Dans certains cas, il peut être utile d'améliorer encore la liaison entre la périphérie du module électronique 146 et le corps de la carte.

Une première solution, représentée sur la figure 12, consiste à prévoir à la périphérie du module des trous 160 qui traversent le support isolant 110 et la métallisation 116. Ces trous présentent une extrémité évasée $160_1$ dans la couche de métallisation 116. Lors de l'implantation du module électronique dans le corps de la carte, le matériau plastique ramolli remonte dans les trous 160 pour former ainsi l'équivalent de rivets 162. La remontée du matériau plastique dans les trous 160 est favorisée par l'action de l'outil 148 à dépression.

Une autre solution représentée sur la figure 9 consiste à déposer une couche de matériau adhésif sur la face non métallisée du support isolant 110 du module électronique, à l'extérieur de la zone occupée par les fenêtres 112 et 114. Cette couche de matériau est référencée 164 sur la figure 9. Ce matériau adhésif est par exemple un polyester. Lors du chauffage du module la couche de matériau adhésif est ramollie et adhère fortement au matériau plastique formant le corps de la carte. Cette solution est surtout intéressante dans le cas où le support isolant a une surface très peu rugueuse. Cela peut se présenter lorsque le support est réalisé en KAPTON.

Il est important de souligner à nouveau les avantages du procédé d'implantation selon l'invention. Du fait que c'est la périphérie du substrat isolant qui sert de poinçon pour créer son propre logement dans le corps de la carte avec fusion ou ramollissement du matériau plastique, on a une très bonne adhérence entre le subtrat isolant du module électronique et le corps de la carte. En outre, comme l'échauffement du matériau plastique est réalisé à travers le module électronique lui-même, cet échauffement est très localisé, et comme, de plus, seule la périphérie du substrat isolant pénètre dans le matériau plastique, la quantité de matière refoulée est très réduite. Cela entraîne seulement une déformation de la paroi $142_1$ de l'orifice 142 ménagé dans la carte. Enfin, cette déformation de la paroi interne de l'orifice 142 permet encore d'améliorer l'adhérence entre le dépôt de résine époxy 156 et le corps de la carte. Cela permet globalement d'obtenir une très bonne liaison entre le corps de la carte et le module électronique, ce qui est bien sûr nécessaire pour que la carte ainsi terminée puisse satisfaire aux exigences de résistance mécanique aux pliages requises pour une telle carte.

Dans les exemples décrits, le circuit électronique est formé par une seule pastille semi-conductrice. Il va de soi que l'on ne sortirait pas de l'invention si le circuit électronique nécessitait deux pastilles ou plus. Dans ce cas, il suffirait de prévoir plusieurs fenêtres centrales telles que 12 ou une seule fenêtre centrale ayant des dimensions suffisantes pour permettre de loger les pastilles.

## Revendications

1. Procédé de fabrication de carte à mémoire du type comprenant un circuit intégré noyé à l'intérieur du matériau plastique constituant le support de la carte et selon lequel on fournit un module électronique (20) comprenant un substrat isolant (13) muni de plages de contact métallisées (11) disposées sur une première face (13') dudit substrat, et une pastille formant un circuit intégré (16) montée sur une deuxième face dudit substrat, ledit module ayant une épaisseur inférieure à l'épaisseur de ladite carte, caractérisé en ce que :

on porte localement, à sa température de ramollissement, ledit matériau plastique à l'emplacement où on veut enfoncer ledit module ; et

simultanément, on applique avec pression ledit module (20) sur une face de ladite carte audit emplacement ramolli pour enfoncer ledit module dans ledit matériau jusqu'à ce que ledit module électronique soit disposé dans l'épaisseur de ladite carte et que lesdites plages de contact affleurent sensiblement ladite face de la carte ; ledit procédé comportant en outre l'étape de relier électriquement les bornes dudit circuit intégré auxdites plages de contact métallisées lors de la fourniture dudit module électronique ou après l'implantation dudit module électronique dans le support de la carte.

2. Procédé selon la revendication 1, caractérisé en ce que, pour fournir ledit module électronique, on monte ledit circuit intégré (16) sur ledit substrat (13) qui comporte en outre des métallisations (14) sur ladite deuxième face ; on relie électriquement les bornes (17) dudit circuit intégré auxdites métallisations (14), et on enrobe le circuit intégré et son réseau de connexions dans un enrobage (19) électriquement isolant d'épaisseur telle que l'épaisseur du module formé par le substrat et l'enrobage soit inférieure à l'épaisseur de la carte, et on laisse durcir ledit enrobage.

3. Procédé selon la revendication 1, caractérisé en ce que, avant de chauffer ledit matériau on ménage dans ladite carte (10) un orifice (30) la traversant de part en part, la section droite dudit orifice par un plan parallèle à celui des faces de ladite carte étant supérieure à la surface dudit circuit intégré et inférieure à celle dudit substrat isolant, ledit module étant appliqué sur ladite face de la carte pour que ledit circuit intégré pénètre librement dans ledit orifice, et en ce que, après l'enfoncement dudit module, on remplit la partie restante dudit orifice avec un matériau isolant.

4. Procédé selon la revendication 3, caractérisé en ce que ledit substrat isolant comporte des métallisations (14) sur sa deuxième face, en ce qu'après l'étape d'enfoncement dudit module on réalise des connexions électriques (18) entre les bornes dudit circuit intégré et les métallisations (14) de la deuxième face dudit substrat et en ce qu'on remplit la partie restante dudit orifice (30) avec un matériau isolant (32).

5. Procédé selon l'une quelconque des revendications 2 à 4, caractérisé en ce qu'on fournit un module électronique muni, de plus, d'orifices (15) traversant de part en part ledit substrat, hors du champ dudit circuit intégré, et en ce que, durant l'enfoncement dudit module, on fait pénétrer ledit matériau plastique dans lesdits orifices pour assurer au moins en partie la fixation dudit module dans ledit matériau plastique.

6. Procédé selon la revendication 5, caractérisé en ce que pour fournir ledit module, on recouvre la paroi interne d'au moins certains desdits orifices (15) ménagés dans ledit substrat (13) d'un revêtement conducteur pour relier électriquement lesdites plages de contact (11) et lesdites métallisations (14) sur ladite deuxième face du substrat.

7. Procédé selon la revendication 2, caractérisé en ce que ledit matériau d'enrobage (19) est une résine époxy.

8. Procédé selon l'une quelconque des revendications 1 à 7, caractérisé en ce que, pour porter localement ledit matériau plastique à sa température de ramollissement, on chauffe le module électronique.

9. Procédé selon la revendication 3, caractérisé en ce qu'on fournit un module électronique (146) dans lequel le support isolant (110) est muni sur une de ses faces d'une pluralité de zones conductrices formant lesdites plages de contact, ledit support isolant (110) étant muni en outre d'une fenêtre centrale (112) et de fenêtres périphériques (114), chaque fenêtre étant disposée vis-à-vis d'une desdites zones conductrices ; et ladite pastille (118), qui est logée au moins partiellement dans ladite fenêtre centrale (112) et dont une face est fixée sur ladite zone conductrice (132) disposée vis-à-vis de ladite fenêtre centrale (112).

10. Procédé selon la revendication 9, caractérisé en ce que, pour fournir ledit module électronique, on ménage dans ledit support isolant lesdites fenêtres centrales (112) et périphériques (114), on réalise sur une face dudit support une couche métallique (116) et on grave ladite couche pour définir lesdites plages de contact (130, 132) pour qu'une plage de contact soit disposée vis-à-vis de chaque fenêtre, on place ladite pastille (118) dans ladite fenêtre (112) et on fixe, par sa face ($118_1$) dépourvue de bornes de connexion, ladite pastille sur la plage de contact (132) correspondante pour établir une liaison électrique entre ladite pastille et ladite plage de contact.

11. Procédé selon la revendication 10, caractérisé en ce que de plus, pour fournir ledit module, on fixe une première extrémité d'un fil de connexion (122) sur chaque borne de connexion ($118_2$) de ladite pastille, et on fait pénétrer l'autre extrémité dudit fil (122) dans une desdites fenêtres périphériques (114) et on fixe ladite autre extrémité sur la plage de contact (130) correspondante.

12. Procédé selon la revendication 10, caractérisé en ce que, pour établir lesdites liaisons électriques, on fixe une première extrémité d'un fil de connexion (122) sur chaque borne de connexion ($118_2$) de ladite pastille (116) et on introduit l'autre extrémité dudit fil (122) dans une desdites fenêtres périphériques (114) et on fixe ladite autre extrémité sur la plage de contact (130) correspondante, après avoir provoqué l'enfoncement dudit module dans ledit matériau.

13. Procédé selon l'une quelconque des revendications 9 à 12, caractérisé en ce que, de plus, pour fournir ledit module électronique, on ménage à travers ledit support isolant et au moins une desdites plages de contact au moins un trou (60) présentant une extrémité évasée ($160_1$) dans ladite plage de contact (130, 132) et en ce que durant l'étape d'enfoncement du module dans le matériau ramolli on fait remonter une partie dudit matériau plastique ramolli dans ledit trou pour former un rivet (162) après le refroidissement dudit matériau.

14. Carte à mémoire du type comprenant dans une feuille de matériau plastique un module électronique (20) comportant une pastille formant un circuit intégré (16) montée sur une face d'un substrat isolant (13) présentant des plages de contact métallisées (11) au niveau de la surface de ladite feuille, lesdites plages (11) étant disposées sur la face (13') du substrat opposée à celle sur laquelle est montée la pastille (16) et reliées aux bornes (17) du circuit (16) par un réseau de connexions, caractérisée en ce que la feuille de matériau plastique présente un logement (30) formé au moins en partie par enfoncement dudit module (20) dans celle-ci, et en ce que ledit substrat isolant (13) comporte une pluralité d'orifices (15) au moins partiellement remplis par le matériau plastique formant ladite feuille.

15. Carte selon la revendication 14, caractérisée en ce que la paroi d'au moins certains desdits orifices (115) est métallisée pour relier électriquement lesdites plages de contact (11) audit réseau de connexions (14).

16. Carte selon l'une quelconque des revendications 14 et 15 caractérisée en ce que l'extrémité (15a) des orifices (15) tournée vers ladite pastille (16) est évasée pour que le matériau plastique remplissant lesdits orifices joue le rôle d'un rivet.

17. Carte à mémoire selon la revendication 14 caractérisée en ce que ledit substrat isolant comprend en outre une fenêtre centrale (112) dans laquelle est logée au moins partiellement ladite pastille (118) et des fenêtres périphériques (114) dans lesquelles est logée une des extrémités desdites connexions électriques (122), et en ce que ledit corps de la carte (140) comprend un orifice (142), débouchant dans sa deuxième face, dans lequel sont logés une partie de ladite pastille et lesdites connexions électriques, ledit orifice étant rempli par un matériau isolant (156) qui remplit également la portion de la fenêtre centrale non occupée par la pastille et lesdites fenêtres périphériques.

**Claims**

1. A method of manufacturing a memory card of the type including an integrated circuit embedded inside plastic material constituting the support of the card and according which an electronic module (20) is provided including an insulating substrate (13) equipped with metal plated contact areas (11) located on a first face (13) of said substrat, and a chip forming an electronic circuit (16) mounted on a second face of said substrate, said module having a thickness smaller than the thickness of said card, characterized in that :

said plastic material is locally heated to its softening temperature at the location at which said module is to be embedded ;

simultaneously, applying with pressure said module (20) on one face of said card at said softened location to embed said module in said plastic material until said electronic module is placed in the thickness of said card and contact areas are substantially flush with said face of the card ; said method further comprising the step of electrically connecting the terminals of said integrated circuit to said metal-plated contact areas either when said electronic module is provided or after said electronic module is embedded in the support of the card.

2. A method according to claim 1, characterized in that, in order to provide said electronic module, said integrated circuit (16) is mounted on said substrate (13) which further comprises metal platings (14) on said second face ; the terminals (17) of said integrated circuit are electrically connected to said metal platings (14) and said integrated circuit and its connection network are coated with an electrically insulating coating (19) with a thickness such that the thickness of the module formed by the substrate and the coating is less than the thickness of the card, and said coating is allowed to harden.

3. A method according to claim 1, characterized in that, before heating said material an orifice (30) is formed through the thickness of the card, the cross section of said orifice through a plane parallel to that of the faces of said card being greater than the surface of said integrated circuit and smaller than that of said insulating substrate, said module being applied on said face of the card so that said integrated circuit penetrates freely into said orifice, and in that, after the embeddement of said module, the remaining part of said orifice is filled with an insulating material.

4. A method according to claim 3, characterized in that said insulating substrate includes metal platings (14) on its second face, in that, after said module has been embedded, electrical connections (18) are made between the terminals of said integrated circuit and said metal platings (14) of the second face of said substrate, and in that the remaining part of said orifice (30) is filled with an insulating material (32).

5. A method according to anyone of claims 2 to 4, characterized in that the provided electronic module is further formed with orifices (15) going through said substrate outside of the area of said integrated circuit, and in that, during the driving in of said module, said plastic material is made to penetrate into said orifices to ensure at least partial fixing of said module in said plastic material.

6. A method according to claim 5, characterized in that, to provide said module, the internal wall of at least some of said orifices (15) made in said substrate (13) is covered with a conducting coating to provide an electrical connection between said contact areas (11) and said metal platings (14) on said second face of the substrate.

7. A method according to claim 2, characterized in that said coating material (19) is an epoxy resin.

8. A method according to anyone of claims 1 to 7, characterized in that, in order to locally heat the plastic material to its softening temperature, the electronic module is heated.

9. A method according to claim 3, characterized in that, the insulating substrate (10) of the provided electronic module (146) comprises on one of its faces a plurality of conducting zones forming said contact areas, said insulating substrate (110) further including a central window (112) and peripheral windows (114), each window facing one of said conducting zones ; and said chip (118) is at least partially located within central window (112), one face of said chip being fixed on said conducting zone (132) facing said central window (112).

10. A method according to claim 9, characterized in that, in order to provide said electronic module, said central window (112) and said peripheral windows (114) are formed within said insulating substrate, a metallic layer (116) is disposed on one face of said substrate and said layer is etched to define said contact areas (130, 132) so that one contact area faces each window, said chip (118) is placed into said window (112) and the chip face (118$_1$) without terminals is fixed on the corresponding contact area (132) so that an electrical connection between said chip and said contact area is made.

11. A method according to claim 10, characterized in that, the providing of said module further includes the steps of fixing the first end of a connecting wire to each terminal (118$_2$) of said chip, and introducing the other end of said wire (122) into one of said peripheral windows (114) and fixing said other end to the corresponding contact area (130).

12. A method according to claim 10, characterized in that in order to make said electrical connections, a first end of a connecting wire (122) is fixed to each terminal (118$_2$) of said chip (116), the other end of said wire (122) is introduced into one of said peripheral windows (114) and said other end is fixed to said corresponding contact area 130, after said module have been driven into said material.

13. A method according to anyone of claims 9 to 12, characterized in that the providing of the electronic module further comprises the step of providing and least one hole (60) passing through said insulating substrate at least one of said contact areas, said hole having a flared end (160$_1$) in said contact area (130, 132) and in that, during the driving in of the module in the softened material, a part of said softened plastic material is made filling said hole, to act as a rivet (162) after the cooling of said material.

14. A memory card comprising, in a sheet of plastic material, an electronic module (20) including a chip forming an integrated circuit (16) mounted on one face of an insulating substrate (13) having metal platted contact areas (11) at the level of the surface of said sheet, said contact areas (11) being disposed on the face (13') of the substrate which is opposed to the face on which the chip (16) is mounted, and connected to the terminals (17) of the circuit (16) by means of a connecting network, said memory card being characterized in that a cavity (30) is provided within said plastic material sheet, said cavity being formed at least partially by the driving in of said module (20) into said sheet, and in that said insulating substrate (13) includes a plurality of orifices (15) at least partially filled with the plastic material forming said sheet.

15. A card according to claim 14, characterized in that the wall of at least some of said orifices (115) are metal plated for electrically connecting said contact areas (11) with said connecting network (14).

16. A card according to anyone of claims 14 and 15, characterized in that the end of said orifices toward said chip (16) are flared so that the plastic material which fills said orifices acts as a rivet.

17. A memory card according to claim 14, characterized in that said insulating substrate further comprises a central window (112) wherein said chip (118) is at least partially located and peripheral windows (114) wherein one of the ends of the electrical connections (122) are located, and in that said card body (140) comprises an orifice (142), issuing in its second face, wherein a part of said chip and said electrical connections are located, said orifice being filled with an insulating material (156) which also fills the part of the central window not occupied by the chip and said peripheral windows.

**Patentansprüche**

1. Verfahren zum Herstellen von Speicherkarten des Typs, der einen in das Innere von Kunststoffmaterial, das den Kartensupport bildet, versenkten, integrierten Schaltkreis umfaßt, bei welchem man einen elektronischen Modul (20) bereitstellt, der ein isolierendes Substrat (13), versehen mit metallisierten Kontaktfeldern (11) auf einer ersten Seite (13') des genannten Substrats umfaßt, sowie eine auf einer zweiten Seite des genannten Substrats montierten, einen integrierten Schaltkreis (16) bildenden Pille, wobei der genannte Modul eine Dicke aufweist, die kleiner ist als die Dicke der genannten Karte, dadurch gekennzeichnet, daß :

man lokal das genannte Kunststoffmaterial an der Stelle, wo der genannte Modul zu versenken ist, auf seine Erweichungstemperatur bringt, und

man gleichzeitig mit Druck den genannten Modul (20) auf einer Seite der genannten Karte an der erweichten Stelle unter Druck aufbringt zum Versenken des genannten Moduls in das genannte Material, bis der genannte elektronische Modul in der Dicke der genannten Karte angeordnet ist und die genannten Kontaktfelder im wesentlichen mit der genannten Kartenseite bündig sind ; wobei das genannte Verfahren ferner die Etappe umfaßt, elektrisch die Klemmen des genannten integrierten Schaltkreises mit den genannten metallisierten Kontaktfeldern vor dem Bereitstellen des genannten elektronischen Moduls zu verbinden oder nach dem Einsenken des genannten elektronischen Moduls in·den Support der Karte.

2. Verfahren nach Anspruch 1, dadurch gekennzeichnet, daß man für das Bereitstellen des genannten elektronischen Moduls den genannten integrierten Schaltkreis (16) auf dem genannten Substrat (13) montiert, das ferner die Metallisierungen (14) auf der genannten Seite umfaßt ; man elektrisch die Klemmen (17) des genannten integrierten Schaltkreises mit den genannten Metallisierungen (14) elektrisch verbindet und man den integrierten Schaltkreis und sein Verbindungsnetzwerk in eine elektrisch isolierende Umhüllung (19) einbettet, die eine Dicke derart besitzt, daß Die Dicke des durch das Substrat und die Umhüllung gebildeten Moduls kleiner ist als die Dicke der Karte und daß man die genannte Umhüllung aushärten läßt.

3. Verfahren nach Anspruch 1, dadurch gekennzeichnet, daß man vor dem Erwärmen des genannten Materials in die genannte Karte (10) eine Öffnung (30) einbringt, die sie von einer Seite zur anderen durchsetzt, wobei der Querschnitt der genannten Öffnung in einer Ebene parallel zu derjenigen der Seiten der genannten Karte größer ist als die Oberfläche des genannten integrierten Schaltkreises und kleiner als der des genannten isolierenden Substrats, wobei der genannte Modul auf die genannte Seite der Karte aufgebracht wird, derart, daß der genannte integrierte Schaltkreis frei in die genannte Öffnung eindringt und daß man nach dem Einsenken des genannten Moduls den verbleibenden Teil der genannten Öffnung mit einem isolierenden Material füllt.

4. Verfahren nach Anspruch 3, dadurch gekennzeichnet, daß das genannte isolierende Substrat Metallisierungen (14) auf seiner zweiten Seite aufweist, daß man nach dem Schritt des Einsenkens des genannten Moduls elektrische Verbindungen (18) zwischen den Klemmen des genannten integrierten Schaltkreises und den Metallisierungen (14) der zweiten Seite des genannten Substrats herstellt und daß man den verbleibenden Teil der genannten Öffnung (30) mit einem isolierenden Material (32) füllt.

5. Verfahren nach einem der Ansprüche 2 bis 4, dadurch gekennzeichnet, daß man einen elektronischen Modul bereitstellt, der zusätzlich mit Öffnungen (15) versehen ist, welche das Substrat außerhalb des Bereichs des genannten integrierten Schaltkreises durchsetzen und daß man während des Einsenkens des genannten Moduls das genannte Kunststoffmaterial in die genannten Öffnungen eindringen läßt zum mindestens teilweisen Sicherstellen der Festlegung des genannten Moduls in dem genannten Kunststoffmaterial.

6. Verfahren nach Anspruch 5, dadurch gekennzeichnet, daß man für die Bereitstellung des genannten Moduls die Innenwandung mindestens bestimmter Öffnungen (15), die in das genannte Substrat (13) eingebracht sind, mit einer leitenden Beschichtung versieht, um elektrisch die genannten Kontaktfelder (11) und die genannten Metallisierungen (14) auf der genannten zweiten Seite des Substrats zu verbinden.

7. Verfahren nach Anspruch 2, dadurch gekennzeichnet, daß das genannte Umhüllungsmaterial (19) ein Epoxyharz ist.

8. Verfahren nach einem der Ansprüche 1 bis 7, dadurch gekennzeichnet, daß man zum lokalen Bringen des Kunststoffmaterials auf seine Erweichungstemperatur den elektrischen Modul erhitzt.

9. Verfahren nach Anspruch 3, dadurch gekennzeichnet, daß man einen elektronischen Modul (146) bereitstellt, bei dem der isolierende Support (110) auf einer seiner Seiten mit einer Mehrzahl von leitenden Zonen versehen ist, die die genannten Kontaktfelder bilden, wobei der genannte isolierende Support (110) ferner mit einem zentralen Fenster (112) versehen ist sowie mit peripheren Fenstern (114), wobei jedes Fenster gegenüber einer der genannten leitenden Zonen angeordnet ist und daß die genannte Pille (118), die mindestens teilweise in dem genannten zentralen Fenster (112) positioniert ist und deren eine Seite auf der genannten leitenden Zone (132) gegenüber dem genannten zentralen Fenster (112) befestigt ist.

10. Verfahren nach Anspruch 9, dadurch gekennzeichnet, daß man für die Bereitstellung des genannten elektronischen Moduls in den genannten isolierenden Support die genannten zentralen (112) und peripheren (114) Fenster einbringt, daß man auf einer Seite des genannten Supports eine metallische Schicht (116) aufbringt und daß man die genannte Schicht graviert zum Begrenzen der genannten Kontaktfelder (130, 132), derart, daß ein Kontaktfeld gegenüber jedem Fenster angeordnet ist, daß man die genannte Pille (118) in das genannte Fenster (112) einbringt und die genannte Pille mit ihrer Seite (118₁) frei von Anschlußklemmen auf dem entsprechenden Kontaktfeld (132) befestigt zum Herstellen einer elektrischen Verbindung zwischen der genannten Pille und dem genannten Kontaktfeld.

11. Verfahren nach Anspruch 10, dadurch gekennzeichnet, daß man zusätzlich für die Bereitstellung des genannten Moduls ein erstes Ende eines Verbindungsdrahtes (122) an jeder Anschlußklemme (118$_2$) der genannten Pille befestigt, und daß man das andere Ende des genannten Drahtes (122) in eines der genannten peripheren Fenster (114) eindringen läßt und das genannte andere Ende auf dem entsprechenden Kontaktfeld (130) befestigt.

12. Verfahren nach Anspruch 10, dadurch gekennzeichnet, daß man zum Herstellen der genannten elektrischen Verbindungen ein erstes Ende eines Verbindungsdrahtes (122) an jeder Verbindungsklemme (118$_2$) der genannten Pille (116) befestigt und das andere Ende des genannten Drahtes (122) in eines der genannten peripheren Fenster (114) eindringen läßt und das genannte andere Ende auf dem entsprechenden Kontaktfeld (130) befestigt, nachdem man das Einsenken des genannten Moduls in das genannte Material bewirkt hat.

13. Verfahren nach einem der Ansprüche 9 bis 12, dadurch gekennzeichnet, daß man zusätzlich für die Bereitstellung des genannten elektronischen Moduls quer zu dem genannten isolierenden Support und mindestens einem der genannten Kontaktfelder mindestens ein Loch (60) einbringt, das ein sich erweiterndes Ende (160$_1$) in dem genannten Kontaktfeld (130, 132) aufweist, und das während des Schrittes des Einsenkens des Moduls in das erweichte Material einen Teil des genannten erweichten Kunststoffmaterials in das genannte Loch aufsteigen läßt zum Bilden eines Niets (162) nach Wiederabkühlung des genannten Materials.

14. Speicherkarte des Typs umfassend, in einem Kunststoffmaterialblatt, einen elektronischen Modul (20), umfassend eine integrierten Schaltkreis (16) bildende Pille, montiert auf einer Seite eines isolierenden Substrats (13), das metallisierte Kontaktfelder (11) in Höhe der Oberfläche des genannten Blattes aufweist, wobei die genannten Felder (11) auf der Seite (13') des Substrats gegenüber jener angeordnet sind, auf der die Pille (16) montiert ist und mit Klemmen (17) des Schaltkreises (16) durch ein Verbindungsnetzwerk verbunden sind, dadurch gekennzeichnet, daß das Kunststoffmaterialblatt eine Aufnahme (30) aufweist, die mindestens zum Teil durch Einsenken des genannten Moduls (20) in dasselbe gebildet wird und daß das genannte isolierende Substrat (13) eine Mehrzahl von Öffnungen (15) umfaßt, die mindestens teilweise von dem Kunststoffmaterial gefüllt sind, das das genannte Blatt bildet.

15. Karte nach Anspruch 14, dadurch gekennzeichnet, daß die Wandung mindestens bestimmter der genannten Öffnungen (115) metallisiert ist für die elektrische Verbindung der genannten Kontaktfelder (11) mit dem genannten Verbindungsnetzwerk (14).

16. Karte nach einem der Ansprüche 14 und 15, dadurch gekennzeichnet, daß das Ende (15a) der Öffnungen (15), zugewandt der genannten Pille (16), sich erweitert, damit das die genannten Öffnungen füllende Kunststoffmaterial die Rolle eines Niets spielt.

17. Speicherkarte nach Anspruch 14, dadurch gekennzeichnet, daß das genannte isolierende Substrat ferner ein zentrales Fenster (112) umfaßt, in das mindestens teilweise die genannte Pille (118) eingefügt ist sowie periphere Fenster (114), in denen eines der Enden der genannten elektrischen Verbindungen (122) eingefügt ist und daß der genannte Korpus der Karte (140) eine Öffnung (142) umfaßt, die auf seiner zweiten Seite mündet, in der ein Teil der genannten Pille und der genannten elektrischen Verbindungen untergebracht ist, welche Öffnung von einem isolierenden Material (156) gefüllt ist, das gleichermaßen den Abschnitt des zentralen Fensters füllt, der nicht von der Pille beansprucht wird, sowie die genannten peripheren Fenster.

FIG. 1

FIG. 2

FIG. 3

# FIG. 4

15  11  21  13  13'  16  11  21  11  29  15a  10

12  32  17  14  15

# FIG. 5

24  25  23  24'

16  20  12

26

30

0 128 822

FIG. 6

FIG. 7

FIG. 8

FIG. 13

3

# FIG. 9

# FIG. 10 a          FIG. 10 b

# FIG. 12

162  130          118₁  132    114      130  110  160₁      140₁

140          142₁  156  114 112  118    122          160

# FIG. 11

152                154              148
                                              150

                                              110

140₁      146          118        122        140

                                              144

142      142₁